# EUROPEAN PATENT APPLICATION

(11) **EP 2 246 771 A1**
(43) Date of publication of application: **03.11.2010**
(21) Application number: 08872633.6
(22) Date of filing: 18.12.2008
(51) Int. Cl.: G06F 3/023, G06F 3/033, H01H 25/04, H01H 36/00

(54) **INPUT DEVICE AND ELECTRONIC APPARATUS USING THE SAME**

(30) Priority: 18.02.2008 JP 2008036186
(71) Applicant: Omron Corporation, Kyoto-shi, Kyoto 600-8530 (JP)
(72) Inventor: WASHIZU, Tomoyuki, Kyoto-shi Kyoto 600-8530 (JP); MIYASAKA, Takeshi, Kyoto-shi Kyoto 600-8530 (JP); MUROTA, Masayuki, Kyoto-shi Kyoto 600-8530 (JP)
(74) Representative: Giovannini, Francesca
(86) International application number: PCT/JP2008/073084
(87) International publication number: WO 2009/104335

(57) **Abstract**

This invention provides an input device having an excellent operation feeling, and an electronic device using the same. An input device of the present invention is configured by a print substrate having a plurality of electrostatic electrodes arranged on an upper surface at a periphery of a fit-in hole; and a rotation operating body turnably assembled by being fitted to the fit-in hole of the print substrate. A rotation plate of the rotation operating body elastically deforms in a plate thickness direction when the rotation plate is pushed, and returns when pushing is released to give an operation feeling.

## Description

### BACKGROUND OF THE INVENTION

### 1. TECHNICAL FIELD

The present invention relates to an input device that can be applied to an electronic device such as a mobile phone, a PC, a PDA, a television, and a video, and an electronic device using the same.

### 2. RELATED ART

An input device using a sensor for detecting change in the electrostatic capacity is conventionally known. In such input device, the electrostatic capacity of a capacitor embedded in the print substrate is changed by touching with a finger. Since the capacitor of the sensor is arranged in a lattice form, the trace of the finger moving on the surface of the sensor can be known from the trace where the electrostatic capacity changed, and used in the operation of scroll and the like on the monitor.

For instance, in the input device according to Japanese Unexamined Patent Publication No. 2007-42489, a signal corresponding to the rotation amount and the rotating direction is output from an output unit to an external circuit through a control circuit by rotating a rotation operator. The change in electrostatic capacity corresponding to the push-in movement is output from the output unit to the external circuit through the control circuit by pushing the rotation operator. Such signals are displayed on a display unit of an AV device incorporating the input device, so that the selected set item can be execution processed (see Japanese Unexamined Patent Publication No. 2007-42489).

However, the rotation operator of the conventional input device has a rotation shaft arranged on a rotation plate having a uniform plate thickness. Thus, the distance between the rotation plate and the print substrate is uniform, whereby the desired operation feeling is not obtained even if the rotation operator is push operated.

### SUMMARY

The present invention has been devised to solve the problems described above, and an object thereof is to provide an input device having an excellent operation feeling, and an electronic device using the same.

As means for solving the above problems, in one aspect of the present invention, an input device of the present invention includes a print substrate having a plurality of electrostatic electrodes arranged on an upper surface at a periphery of a fit-in hole; and a rotation operating body turnably assembled by being fitted to the fit-in hole of the print substrate; wherein a rotation plate of the rotation operating body elastically deforms in a plate thickness direction when the rotation plate is pushed, and returns when pushing is released to give an operation feeling; and an electronic device uses the same.

According to such configuration, the rotation operating body elastically deforms in the plate thickness direction when the finger pushes the rotation operating body in operating the rotation operating body, so that the rotation operating body approaches the print substrate and the electrostatic electrode of the input unit changes. The operator obtains a stable feeling by giving an operation feeling of the rotation plate elastically returning.

In one embodiment, a plate thickness of the rotation operating body preferably becomes thinner radially outward.
According to such configuration, the push-in amount in the pushing operation can be increased as the plate thickness of the rotation operating body becomes thinner radially outward. The operation feeling of the rotation plate elastically returning thus increases, and the operation feeling of the input device can be enhanced.
The contacting area of the rotation operating body and the print substrate when the rotation plate of the rotation operating body is pushed becomes small compared to the case in which the plate thickness is uniform. Thus, the friction resistance by rotation torque can be reduced, and an input device having an appropriate friction resistance can be obtained.

In another embodiment, the rotation operating body preferably includes a thick portion at an outer peripheral edge of a surface facing the print substrate.
According to such configuration, the rotation operating body is supported by the rotation shaft and the outer peripheral edge when the rotation plate of the rotation operating body is pushed, and thus the rotation plate of the rotation operating body stabilizes and the operation feeling of the rotation plate elastically returning can be obtained. As a result, the operation feeling of the input device can be enhanced.

In another embodiment, a reinforcement unit is preferably arranged on the upper surface of the print substrate positioned immediately below the rotation operating body.
According to such configuration, the deformation amount of the print substrate can be reduced by reinforcing the print substrate. Thus, the stability of the print substrate in the pushing operation can be increased, and the operation feeling of the input device can be enhanced.

In a different embodiment, a reinforcement bottom plate is preferably arranged at the lower surface of the print substrate positioned immediately below the rotation operating body.
According to such configuration, the deformation amount of the print substrate can be reduced by arranging the reinforcement bottom plate and reinforcing the print substrate. Thus, the stability of the print substrate in the pushing operation can be increased, and the operation feeling of the input device can be enhanced.

In another embodiment, a slidable sheet is preferably arranged between the rotation operating body and the print substrate.
According to such configuration, the rotation operating body can be smoothly slid, and the operation feeling of the input device can be enhanced.

A slidable layer is preferably integrally arranged on at least one of the lower surface of the rotation operating body or the upper surface of the print substrate.
According to such configuration, the rotation operating body can be smoothly slid, and the operation feeling of the input device can be enhanced.

In another aspect of the present invention, an electronic device such as a mobile phone, a PC, a PDA, a television, and a video incorporates an input device including a print substrate having a plurality of electrostatic electrodes arranged on an upper surface at a periphery of a fit-in hole; and a rotation operating body turnably assembled by being fitted to the fit-in hole of the print substrate; wherein a rotation plate of the rotation operating body elastically deforms in a plate thickness direction when the rotation plate is pushed, and returns when pushing is released to give an operation feeling.
According to such configuration, an electronic device having a desired operation feeling can be obtained.

### BRIEF DESCRIPTION OF THE DRAWINGS

Fig. 1 is a front view of a mobile phone incorporating an input device according to the present invention;
Fig. 2A is an enlarged front view of the input device according to the present invention, and Fig. 2B is an enlarged rear view of the input device according to the present invention;
Figs. 3A and 3B are perspective views of the input device shown in Figs. 2A and 2B seen from the up and down direction;
Fig. 4 is an exploded perspective view seen from the upper side of the input device shown in Fig. 3A;
Fig. 5 is an exploded perspective view seen from the lower side of the input device shown in Fig. 3B;
Fig. 6A is a side view of a rotation operating body according to a first embodiment of the present invention, and Fig. 6B is a cross-sectional view taken along line VI-VI of the input device according to the first embodiment of the present invention;
Fig. 7A is a side view of a rotation operating body according to a second embodiment of the present invention, and Fig. 7B is a cross-sectional view of the input device according to the second embodiment of the present invention;
Fig. 8A is a side view of a rotation operating body according to a third embodiment of the present invention, and Fig. 8B is a cross-sectional view of the input device according to the third embodiment of the present invention;
Fig. 9A is a side view of a rotation operating body according to a fourth embodiment of the present invention, and Fig. 9B is a cross-sectional view of the input device according to the fourth embodiment of the present invention;
Fig. 10A is a cross-sectional view taken along line XI-XI of an input device having a reinforcement unit arranged at the upper surface of the print substrate of the input device according to a fifth embodiment of the present invention, Fig. 10B is an enlarged cross-sectional view of region B of the input device according to the fifth embodiment of the present invention, and Fig. 10C is an enlarged cross-sectional view of region C of the input device according to the fifth embodiment of the present invention;
Fig. 11 is a perspective view of the print substrate having a reinforcement unit arranged at the upper surface of the input device according to the fifth embodiment of the present invention; and
Fig. 12 is a cross-sectional view of an input device according to a sixth embodiment of the present invention.

### DETAILED DESCRIPTION

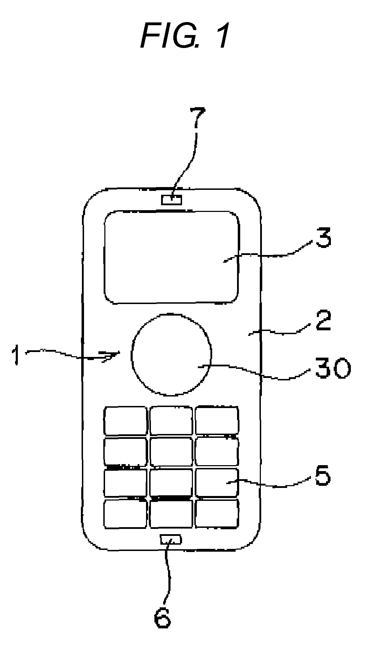

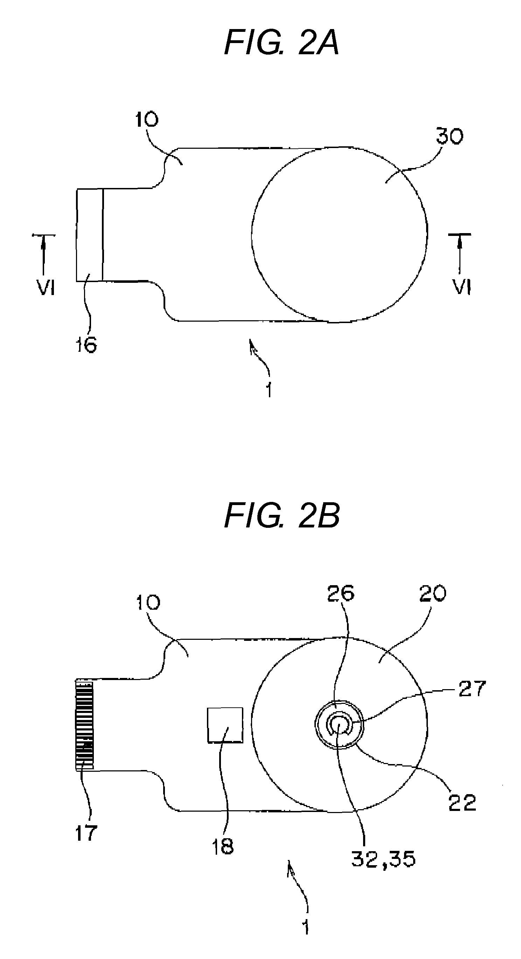

Hereinafter, preferred embodiments of the input device according to the present invention will be described with reference to the accompanied drawings Figs. 1 to 12.
As shown in Figs. 1 to 6, the input device 1 according to the first embodiment is a case applied to a mobile phone 2.
In other words, a scroll bar (not shown) in a monitor 3 arranged on the mobile phone 2 is scrolled by turning a rotation plate 31 of a rotation operating body 30 of the input device 1, and the rotation plate 31 of the rotation operating body 30 can be push operated to give a selection instruction. Here, reference number 5 is a ten key, 6 is a microphone, and 7 is a speaker.

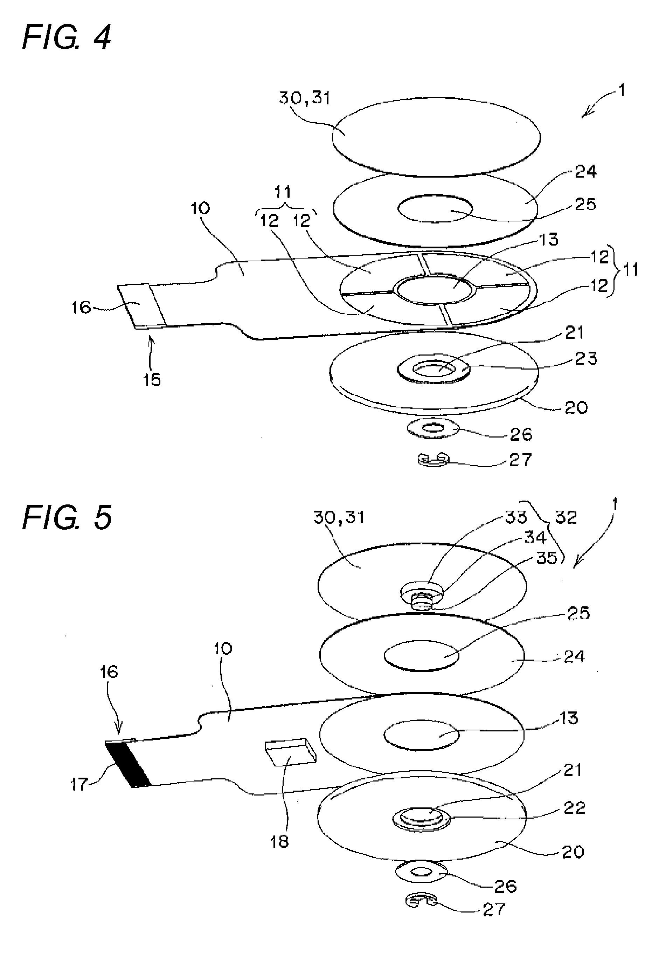

As shown in Figs. 4 and 5, the input device 1 includes a bottom plate (reinforcing bottom plate) 20 arranged at the lower surface of the print substrate 10, a slidable sheet 24 mounted on the upper surface of the print substrate 10, and the rotation operating body 30 attached in a freely turning manner.

The print substrate 10 according to the present example is an FPC (flexible print substrate). The print substrate 10 is made of a flexible resin film, and is configured by integrating a resin film having a predetermined length at a width in the longitudinal direction of an electrode unit 15, and a resin film having a predetermined length at a width of a diameter of an input unit 11. A reinforcing plate 16 is arranged at the upper surface of the print substrate 10, and a metal terminal 17 is arranged at the lower surface. Furthermore, a control element 18 is arranged at the lower surface of the print substrate 10 at a position not overlapping the bottom plate 20 to be fitted.
As shown in Fig. 4, the print substrate 10 has a circular ring-shaped input unit 11 at one end. The input unit 11 includes four electrostatic electrodes 12 divided to ranges of 90 degrees. A signal detected by the electrostatic electrode 12 is output from the electrode unit 15 through the control element 18. A fit-in hole 13 is formed on the inner side of the input unit 11. The electrostatic electrode 12 is adhered with a double-sided tape or an adhesive.

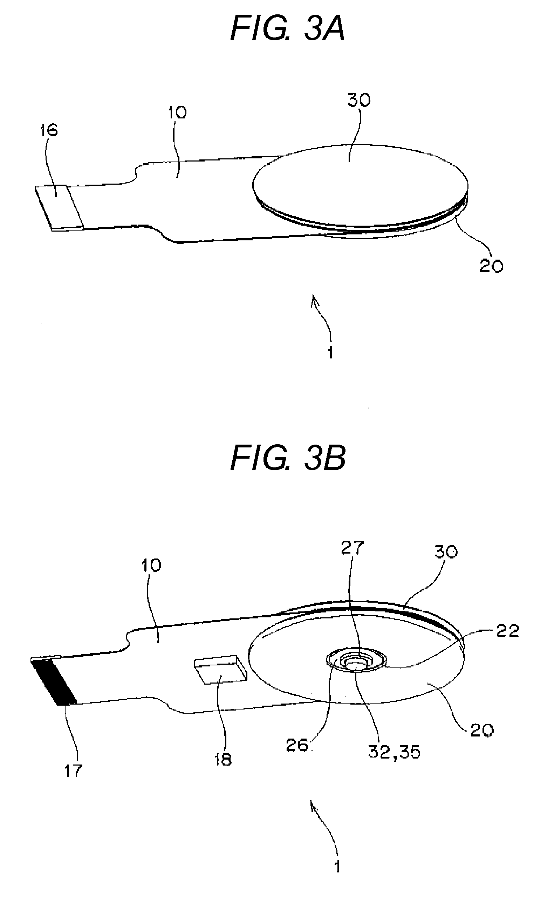

As shown in Figs. 3 to 5, the bottom plate 20 is a circular plate that includes a circular ring-shaped step portion 22 at the lower surface on the periphery of a fit-in hole 21 formed at the center. A circular-ring shaped rib 23 that surrounds the fit-in hole 21 is formed at the upper surface of the bottom plate 20.

As shown in Figs. 4 and 5, the slidable sheet 24 is circular, and includes a fit-in hole 25 at the center.

As shown in Fig. 5, the rotation operating body 30 has a rotation shaft 32 projecting out at the center of the lower surface of the rotation plate 31. In the first example, the rotation shaft 32 includes a narrow-neck portion 34 at a shaft part 35 projecting out from the center of the lower surface of a convex portion 33.

The assembly of the components described above will now be described.
The rotation shaft 32 of the rotation operating body 30 is inserted in the order of the fit-in hole 25 of the slidable sheet 24, the fit-in hole 13 of the print substrate 10, the fit-in hole 21 of the bottom plate 20, and a slip-out preventing plate 26. After the slip-out preventing plate 26 is fitted to the step portion 22 of the bottom plate 20, an E-ring 27 is locked to the narrow-neck portion 34 of the rotation operating body 30 to prevent slip-out.

An operation method of the input device 1 having the above configuration will now be described.
When the rotation operating body 30 is turned, the rotation plate 31 is pushed with the finger, and thus the rotation plate 31 elastically deforms in the plate thickness direction and approaches the input unit 11 of the print substrate 10. Thus, an electrostatic induction generates with the electrostatic electrode 12 in the range where the rotation plate 31 approached, whereby the electrostatic capacity changes. The turning direction and the turning amount of the finger can be detected by tracing back the change in electrostatic capacity. The ON/OFF switch, instruction of input, and the like can be executed even if turning is not carried out and only pushing is carried out. As a result, the desired input can be generated.

In particular, elements for enhancing the operation feeling will be described in the input device 1 according to the present invention. As described above, the operation of the input device 1 is pushing or turning of the rotation plate 31 of the rotation operating body 30. In either operation, the contacting area of the rotation plate 31 and the input unit 11 and/or the cross-sectional shape of the rotation plate 31 are part of the elements for enhancing the operation feeling. The slidable sheet 24 or a slidable layer smoothes the rotation of the rotation operation body 30 when turning the rotation operating body 30, and generates an appropriate sliding friction to maintain the stable feeling of the turn.

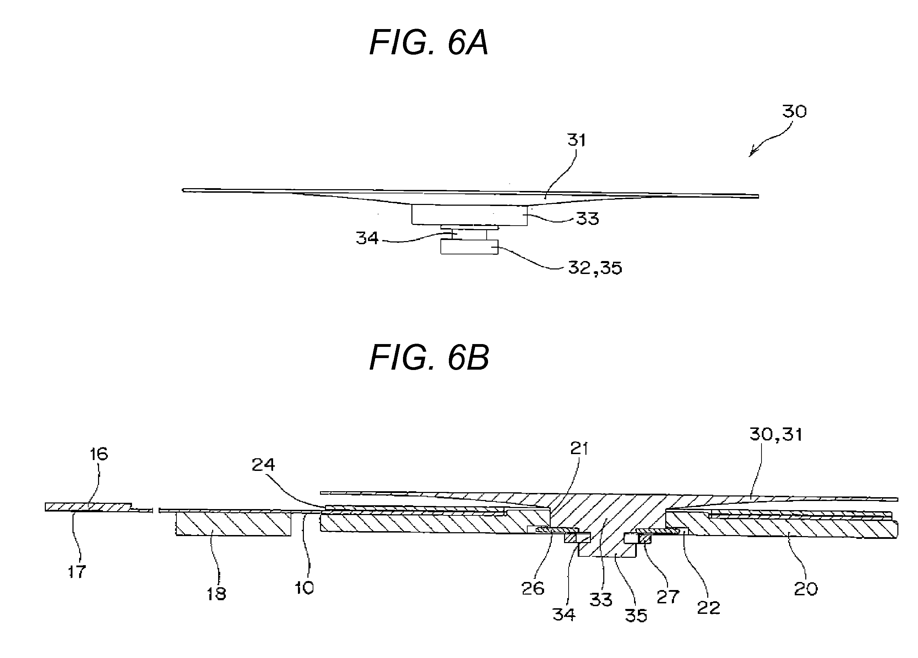

The cross-sectional shape of the rotation plate 31 of the rotation operating body 30 according to the first embodiment shown in Fig. 6A is a curved surface that bulges out to the upper side at the outer periphery of the lower surface excluding the shaft part 35.
The rotation plate 31 of the present embodiment according to the present invention elastically deforms, compared to the flat and smooth rotation plate of the rotation operating body of the prior art, and thus the rotation plate 31 of the rotation operating body 30 can be pushed in. Furthermore, greater push-in amount can be ensured by the shape of the present embodiment compared to the flat and smooth rotation plate. As a result, the operation feeling of the rotation plate 31 elastically returning can be obtained when pushed in, whereby the operation feeling of the input device 1 can be enhanced.

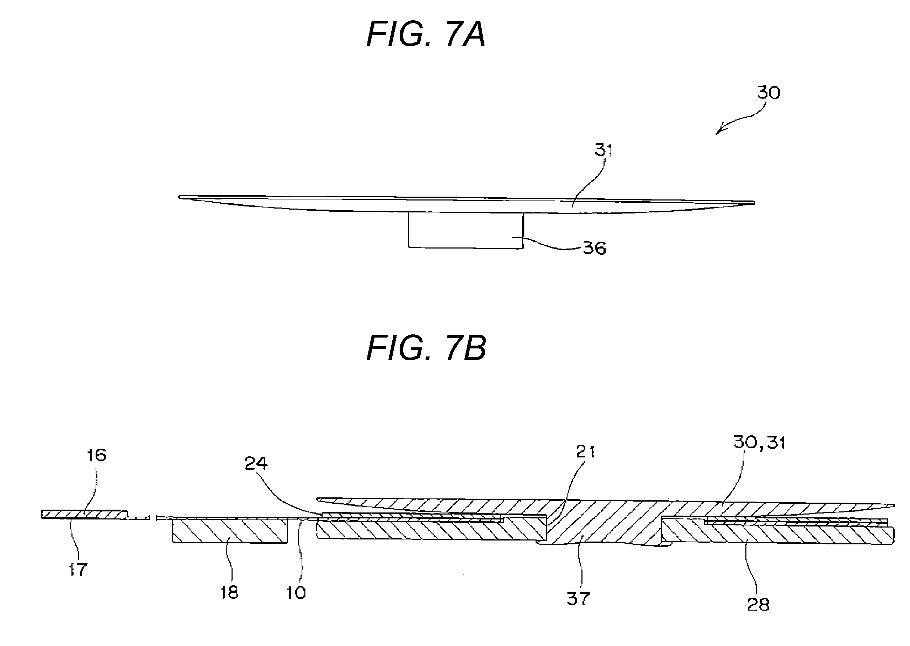

As shown in Figs. 7A and 7B, in a second embodiment, the cross-sectional shape of the rotation plate 31 is a curved surface bulging out radially outward and to the lower side following the flat surface contacting the rotation shaft 36 at the outer periphery of the lower surface excluding the rotation shaft 36.
The rotation operating body 30 has a ground area with the bottom plate 28 through the rotation plate 31 and the slidable sheet 24 ensured to a constant amount at the vicinity of the rotation shaft 36, and thus the stability in the rotating operation can be enhanced compared to the first embodiment.
The rotation plate 31 of the rotation operating body 30 shown in Fig. 7A has the rotation shaft 36 caulked as shown in Fig. 7B and integrated with the bottom plate 28. Such rotation operating body 30 has advantages in that the assembly steps can be reduced and that the manufacturing cost can be reduced.

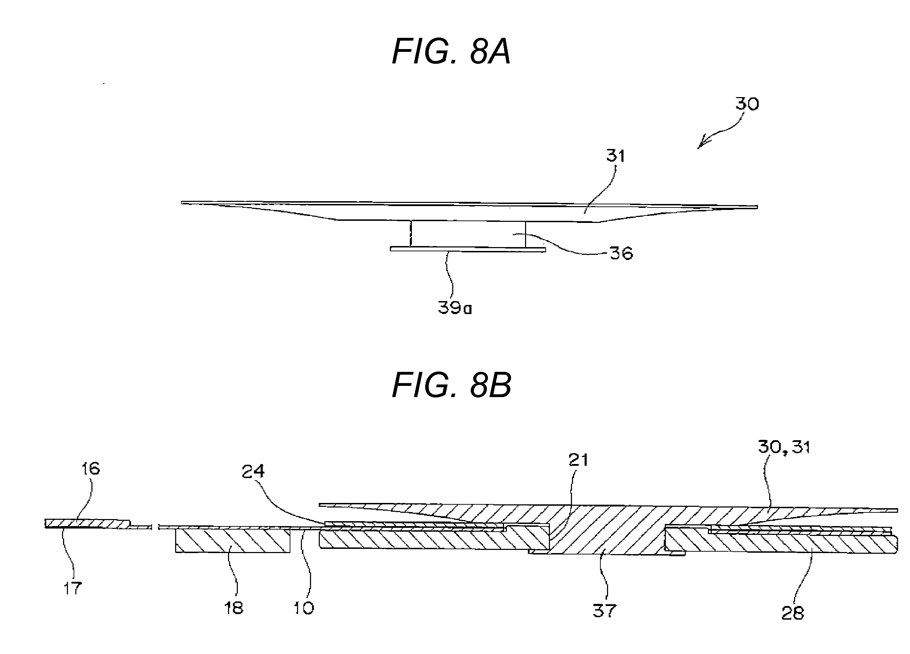

The rotation shaft 36 of the rotation operating body 30 shown in Fig. 8A of a third embodiment shows a caulked rotation shaft 39a.
The cross-sectional shape of the rotation plate 31 is a curved surface bulging out radially outward and to the upper side following the flat surface contacting the rotation shaft 36 at the outer periphery of the lower surface excluding the rotation shaft 36.
Compared to the rotation plate 31 of the rotation operating body 30 according to the second embodiment shown in Fig. 7A, the ground area by the flat surface at the lower surface of the rotation plate 31 is ensured to a constant amount, and the push-in amount of the rotation plate 31 of the rotation operating body 30 is increased radially outward. As a result, the operation feeling of the rotation plate 31 elastically returning can be increased when pushed in, and the operation feeling of the input device 1 can be enhanced.

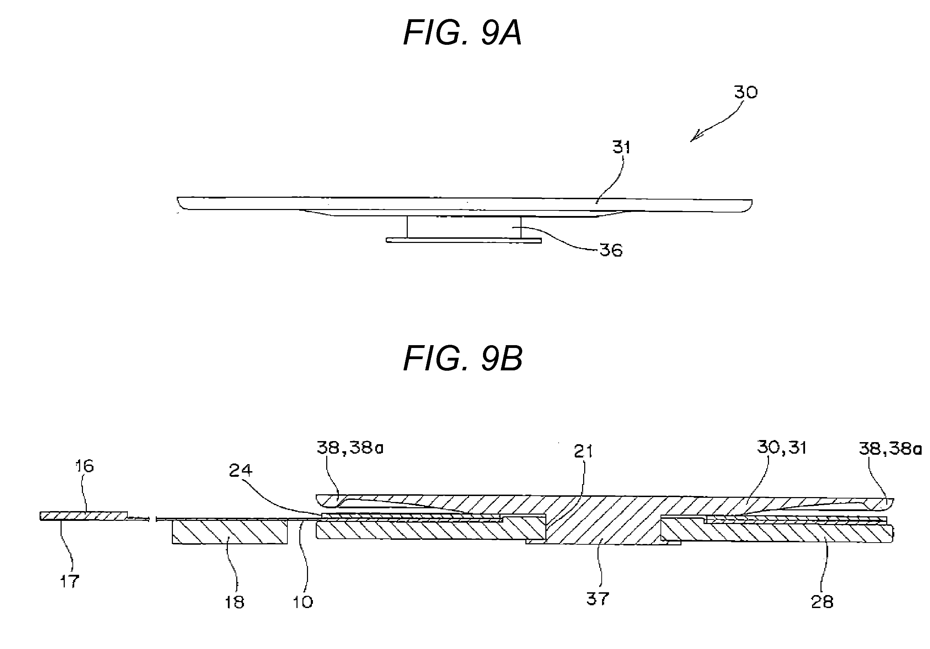

As shown in Figs. 9A and 9B, in a fourth embodiment, the cross-sectional shape of the rotation plate 31 is a curved surface bulging out radially outward and to the upper side following the flat surface contacting the rotation shaft 36 at the outer periphery of the lower surface excluding the rotation shaft 36, similar to the rotation plate 31 of the rotation operating plate 30 according to the third embodiment.
The rotation plate 31 of the rotation operating plate 30 according to the present embodiment further includes a thick portion 38a at the outer peripheral edge 38 of the rotation plate 31. In the rotation plate 31 of the rotation operating plate 30 according to the present embodiment, the rotation plate 31 is supported by the thick portion 38a positioned at the outer most side of the rotation plate 31 when the rotation plate 31 is pushed in. As a result, the operation feeling of the rotation plate 31 elastically returning can be further increased when the rotation plate 31 supported at both sides of the inner side and the outer side in the radial direction of the rotation plate 31 is pushed in, compared to the rotation plate 31 of the rotation operating plate 30 according to the first to the third embodiments. The operation feeling of the input device 1 thus can be further enhanced.
The durability of the rotation plate 31 is also enhanced since the thick portion 38a is arranged at the outer peripheral edge 38 of the rotation plate 31.

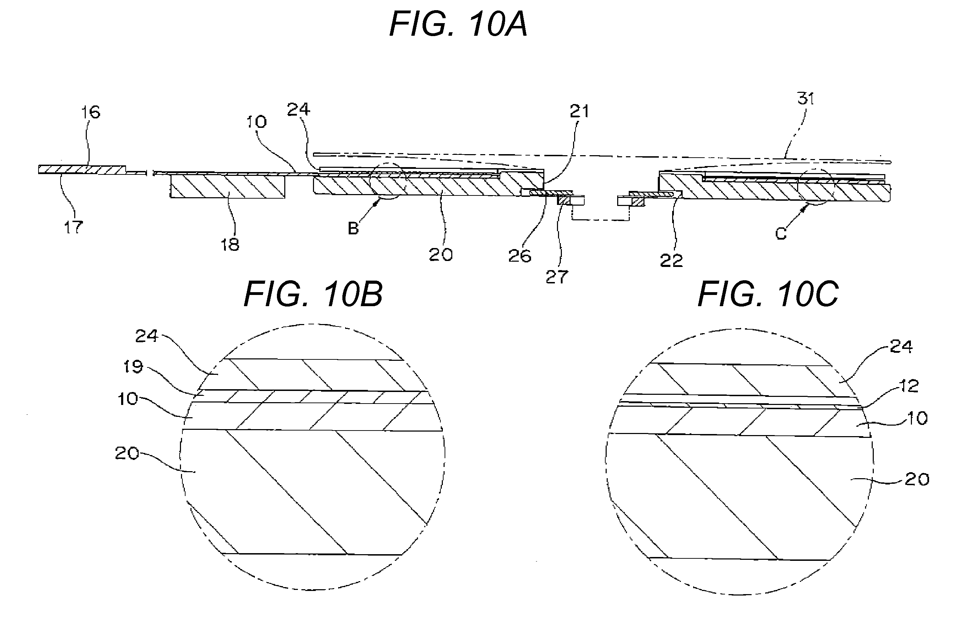

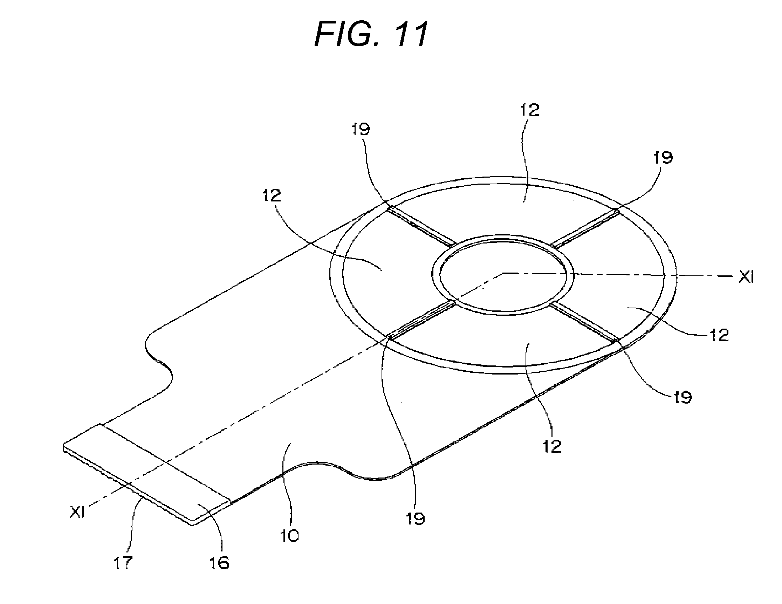

In a fifth embodiment shown in Figs. 10A to 10C and Fig. 11, a reinforcement rib (reinforcement unit) 19 may be arranged in the input unit 11. For instance, the reinforcement rib 19 may be arranged at a position surrounding the electrostatic electrode 12. Such position of the reinforcement rib 19 is one example. Fig. 10B shows an enlarged cross-sectional view of region B of Fig. 10A. Fig. 10C shows an enlarged cross-sectional view of region C of Fig. 10A. As a result of reducing the deformation amount of the print substrate 10 by reinforcing the print substrate 10, the stability of the print substrate 10 at the time of the push operation can be increased, and the operation feeling of the input device 1 can be enhanced. The durability and the smoothing property can also be enhanced. The slidable sheet 24 may be omitted in the present embodiment.

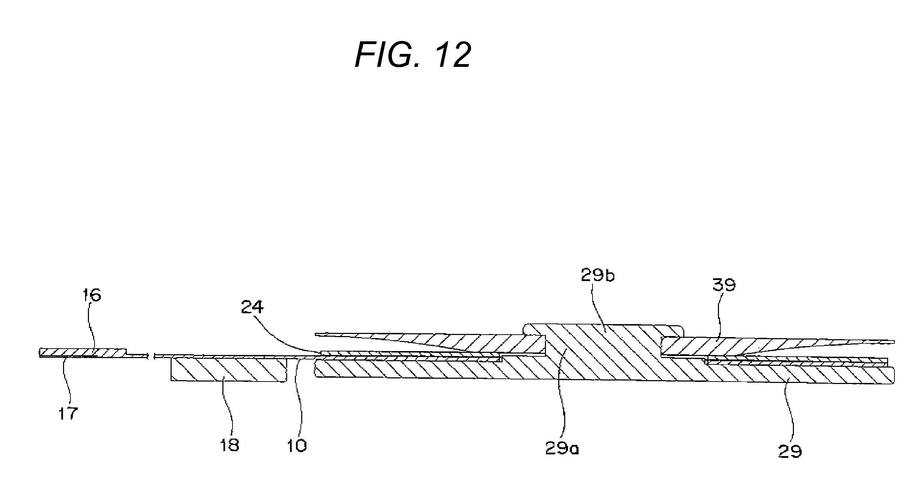

The rotation shaft 29a arranged at the bottom plate 29 may be inserted and fixed to a hole of the rotation operating body 39, as in a sixth embodiment shown in Fig. 12. With such configuration, the formation of the rotation operating body 39 is facilitated. The method of fixing the rotation shafts 32, 36 of the rotation operating body 30 to the bottom plates 20, 28 may be any of caulking (e.g., Fig. 7B), using the E-ring 27, and the like.

In each embodiment, the rotation operating body 30 approaches the print substrate 10 when the rotation operating body 30 bends in the plate thickness direction, and thus the detection sensitivity can be enhanced compared to when the plate thickness of the rotation operating body is uniform.
Furthermore, in the rotation operating body 30 of each embodiment, the contacting area to the print substrate 10 when pushed in with the finger is small compared to when the plate thickness of the rotation operating body is uniform. Thus, an excessive friction resistance due to the rotation torque can be reduced, and an appropriate stable friction resistance can be obtained.

The description made above merely illustratively describes the technical idea of the present invention, and should not be construed as limiting the technical idea of the present invention by the embodiments disclosed in the present invention. Corrections and modifications can be made within the scope of the Claims.

In the present embodiment, the print substrate 10 is an FPC (flexible print substrate), but may be a rigid print substrate such as a glass epoxy substrate.

The slidable layer may be dry fluorine lubricating agent, grease, or the like, and is used by being applied to the upper surface of the input unit 11 of the print substrate 10 or the lower surface of the operation operating body 30.

The input device 1 according to the present invention is not limited to being applied to the mobile phone 2, and may be applied to other mobile devices and electronic devices such as mobile phone, PC, PDA, television, and video having rotation/contact detecting function by the configuration including the rotation operating body 30, 39 of each embodiment, and providing an input device that achieves thinning, input feeling, enhancement of electrostatic sensitivity, and enhancement of slidability. In such a case, the shaft of the rotation operating body 30 is passed through the slidable sheet 24, the print substrate 10, and the like, and integrated (clamped) to the slip-out preventing plate 26 so as to be easily assembled to each electronic device.

The input device according to the present invention is not limited to the mobile phone, and is also obviously applicable to other mobile devices and other electronic devices.

## Claims

1. An input device comprising:
a print substrate having a plurality of electrostatic electrodes arranged on an upper surface at a periphery of a fit-in hole; and
a rotation operating body turnably assembled by being fitted to the fit-in hole of the print substrate; wherein
wherein a rotation plate of the rotation operating body elastically deforms in a plate thickness direction when the rotation plate is pushed, and returns when pushing is released to give an operation feeling

2. The input device according to claim 1, wherein a plate thickness of the rotation operating body becomes thinner radially outward.

3. The input device according to claim 1 or 2, wherein the rotation operating body includes a thick portion at an outer peripheral edge of a surface facing the print substrate.

4. The input device according to any one of claims 1 to 3, wherein a reinforcement unit is arranged on the upper surface of the print substrate positioned immediately below the rotation operating body.

5. The input device according to any one of claims 1 to 4, wherein a reinforcement bottom plate is arranged at the lower surface of the print substrate positioned immediately below the rotation operating body.

6. The input device according to any one of claims 1 to 5, wherein a slidable sheet is arranged between the rotation operating body and the print substrate.

7. The input device according to any one of claims 1 to 6,wherein a slidable layer is integrally arranged on at least one of the lower surface of the rotation operating body or the upper surface of the print substrate.

8. An electronic device incorporating:
an input device including,
a print substrate having a plurality of electrostatic electrodes arranged on an upper surface at a periphery of a fit-in hole; and
a rotation operating body turnably assembled by being fitted to the fit-in hole of the print substrate; wherein
when a rotation plate of the rotation operating body is pushed, the rotation plate elastically deforms in a plate thickness direction, and returns when pushing is released to give an operation feeling.

## Amended claims

### Amended claims under Art. 19.1 PCT

1. An input device comprising:
a print substrate having a plurality of electrostatic electrodes arranged on an upper surface at a periphery of a fit-in hole; and
a rotation operating body turnably assembled by being fitted to the fit-in hole of the print substrate; wherein
wherein a rotation plate of the rotation operating body elastically deforms in a plate thickness direction when the rotation plate is pushed, and returns when pushing is released to give an operation feeling

2. The input device according to claim 1, wherein a plate thickness of the rotation operating body becomes thinner radially outward.

3. The input device according to claim 1, wherein the rotation operating body includes a thick portion at an outer peripheral edge of a surface facing the print substrate.

4. The input device according to claim 1, wherein a reinforcement unit is arranged on the upper surface of the print substrate positioned immediately below the rotation operating body.

5. The input device according to claim 1, wherein a reinforcement bottom plate is arranged at the lower surface of the print substrate positioned immediately below the rotation operating body.

6. The input device according to claim 1, wherein a slidable sheet is arranged between the rotation operating body and the print substrate.

7. The input device according to claim 1,wherein a slidable layer is integrally arranged on at least one of the lower surface of the rotation operating body or the upper surface of the print substrate.

8. An electronic device incorporating:
an input device including,
a print substrate having a plurality of electrostatic electrodes arranged on an upper surface at a periphery of a fit-in hole; and
a rotation operating body turnably assembled by being fitted to the fit-in hole of the print substrate; wherein
when a rotation plate of the rotation operating body is pushed, the rotation plate elastically deforms in a plate thickness direction, and returns when pushing is released to give an operation feeling.
